# EUROPÄISCHE PATENTSCHRIFT

(11) **EP 0 473 136 B1**
(45) Veröffentlichungstag und Bekanntmachung des Hinweises auf die Patenterteilung: **12.06.1996**
(21) Anmeldenummer: 91114452.5
(22) Anmeldetag: 28.08.1991
(51) Int. Cl.: H03K 17/945

(54) **Elektronisches, vorzugsweise berührungslos arbeitendes Schaltgerät**
Electronic switching device, preferably operating without contact
Appareil de commutation électronique, fonctionnant de préférence sans contact

(30) Priorität: 30.08.1990 DE 4027386
(43) Veröffentlichungstag der Anmeldung: 04.03.1992
(73) Patentinhaber: Werner Turck GmbH & Co. KG, D-58553 Halver (DE)
(72) Erfinder: Tigges, Burkhard, 5983 Balve (DE); Sowa Herbert, 9430 Schwarzenberg (DE)
(74) Vertreter: Peerbooms, Rudolf, Dipl.-Phys.

(56) Entgegenhaltungen:
- EP-A- 0 092 711
- DE-U- 8 711 035
- SIEMENS COMPONENTS Bd. 13, Nr. 5, 1. Oktober 1988, BERLIN AND MUNICH Seiten 199 - 202; B. SCHWAGER: 'INTERFERENCE SUPPRESSION FOR INDUCTIVE PROXIMITY SWITCHES USING THE IC TCA 305'

## Beschreibung

Die Erfindung betrifft ein elektronisches, vorzugsweise berührungslos arbeitendes Schaltgerät, mit einer von außen beeinflußbaren Sensorstufe, mit einem von der Sensorstufe steuerbaren elektronischen Lastschalter und mit einer zwischen der Sensorstufe und dem Steuereingang des Lastschalters vorgesehenen, als IC ausgebildeten Schaltung, welche eine Auswertestufe für das Sensorsignal, eine schaltbare Inverterstufe mit Schalteingang und zwei im Gegentakt arbeitende Treiberstufen enthält, wobei der Ausgang der ersten Treiberstufe den Lastschalter ansteuert und der Ausgang der zweiten Treiberstufe - bei der Betriebsart "antivalent" - einen weiteren elektronischen Schalter steuert.

Elektronische Schaltgeräte der zuvor beschriebenen Art haben in elektrischen Meß-, Steuer- oder Regelkreisen die kontaktbehafteten, elektrisch oder mechanisch betätigten Schaltgeräte abgelöst. Das gilt insbesondere für berührungslos auf einen Auslöser ansprechende elektronische Schaltgeräte wie Näherungsschalter. Bei den Näherungsschaltern ändern sich bei Vorhandensein eines Auslösers die elektrischen Eigenschaften eines Sensors, bei dem es sich um einen bedämpfbaren Oszillator, eine Lichtschranke als Beispiel optischer Sensoren oder als weiteres Beispiel um einen Gasdetektor handeln kann. Die von der Sensorstufe abgehenden elektrischen Signale werden, in der Regel vorverstärkt, einer Auswertestufe zugeführt, deren digitales Ausgangssignal für die nachfolgenden Schaltstufen eindeutig festlegt, ob die Sensorstufe auf einen Auslöser angesprochen hat oder nicht. Entsprechend diesem Signal ist von den nachfolgenden Schaltstufen meist einer Treiberstufe und ein daran angeschlossener Lastschalter, ein Laststromkreis zu öffnen oder zu schließen.

Um den Aufwand zu vermeiden, elektronische Schaltgeräte der angesprochenen Art sowohl als öffner als auch als Schließer bauen und lagermäßig bereithalten zu müssen, folgt der Auswertestufe eine Inverterstufe, in der das digitale Ausgangssignal der Auswertestufe nach Bedarf durch Anlegen einer Schaltspannung an den speziellen Schalteingang der Inverterstufe invertiert werden kann. Durch das Anlegen dieser Schaltspannung kann aus einem Näherungsschalter mit Schließercharakteristik ein Näherungsschalter mit öffnercharakteristik gemacht werden (oder umgekehrt).

Im Zuge der Miniaturisierung elektrischer Schaltgeräte der angesprochenen Art werden die Auswertestufe, die schaltbare Inverterstufe sowie die zwei im Gegentakt arbeitenden Treiberstufen in einer integrierten Schaltung, einem IC, raumsparend zusammengefaßt. Der Platzbedarf des IC's richtet sich im wesentlichen nach der Anzahl seiner Anschlüsse, nachfolgend auch IC-Kontakte genannt. Bei dem bekannten Schaltgerät wird ein IC-Kontakt zur Anlage der Schaltspannung für die Inverterstufe benötigt.

Der Erfindung liegt die Aufgabe zugrunde, bei einem gattungsgemäßen Schaltgerät, welches eine IC-Schaltung aufweist, die für die Funktionen "Schließer", "öffner" und "antivalente Lastschalter" verwendbar ist, die Anzahl der benötigten IC-Kontakte zu verringern.

Erfindungsgemäß wird die Aufgabe dadurch gelöst, daß der Schalteingang der Inverterstufe IC-intern an den zweiten Treiberstufenausgang angeschlossen ist, daß der zweite Treiberstufenausgang - für die eine Betriebsart "Schließer" oder "öffner" - durch einen IC-internen Spannungsteiler auf einem Potential gehalten ist, bei dem die Inverterstufe abgeschaltet ist, und daß der zweite Treiberstufenausgang - für die andere Betriebsart "öffner" bzw. "Schließer" - über eine IC-externe Kurzschlußbrücke an das Betriebspotential zwecks Einschaltung der Inverterstufe anschließbar ist.

Durch diese Maßnahmen ist ein gesonderter IC-Kontakt zur Anlage der Schaltspannung für die Einschaltung der Inverterstufe eingespart. Es kann so das IC in einem kleineren IC-Gehäuse aufgebaut werden, wodurch die Größe der Platine des Schaltgerätes reduziert werden kann. Andrerseits besteht aber auch die Möglichkeit, den frei gewordenen IC-Kontakt für weitere Schaltungsfunktionen, z. B. für Anzeigen, zu verwenden.

Um das erfindungsgemäße Schaltgerät auch in der Betriebsart "antivalent" einsetzen zu können, muß die Funktionsfähigkeit der zweiten Treiberstufe, bei entfernter Kurzschlußbrücke, weiterhin gewahrt bleiben. Zu diesem Zweck ist erfindungsgemäß vorgesehen, daß der Spannungsteiler, der das Potential am Schalteingang der Inverterstufe bestimmt, einerseits aus dem Stromableitwiderstand der zweiten Treiberstufe und andrerseits aus der schaltbaren Konstantstromquelle der zweiten Treiberstufe und einer hierzu parallel geschalteten, weiteren Konstantstromquelle besteht.

Da der Schalteingang der Inverterstufe bei der Betriebsart "Öffner" über die IC-externe Kurzschlußbrücke auf dem Potential der maximalen Betriebsspannung liegt, reicht zum Abschalten der Inverterstufe nach Entfernung der Kurzschlußbrücke jedes, gegenüber dem Betriebspotential geringere Potential des zweiten Treiberstufenausganges aus. Es kann daher der Strom der weiteren Konstantstromquelle um etwa zwei Zehnerpotenzen kleiner als der Strom der schaltbaren Treiberstufen-Konstantstromquelle sein.

Zur Festlegung des Potentials des zweiten Treiberstufenausganges ist erfindungsgemäß vorgesehen, daß parallel zum Stromableitwiderstand eine Diodenkette geschaltet ist, die den maximalen Spannungsabfall am Stromableitwiderstand festlegt.

Im folgenden wird die Erfindung anhand einer Zeichnung näher erläutert. Es zeigen:
- Fig. 1: ein elektronisches Schaltgerät nach dem Stand der Technik,
- Fig. 2: ein als Schließer ausgebildetes elektronisches Schaltgerät nach der Erfindung,
- Fig. 3: ein als öffner ausgebildetes elektronisches Schaltgerät nach der Erfindung und
- Fig. 4: ein mit antivalent arbeitenden Schaltern ausgerüstetes Schaltgerät nach der Erfindung.

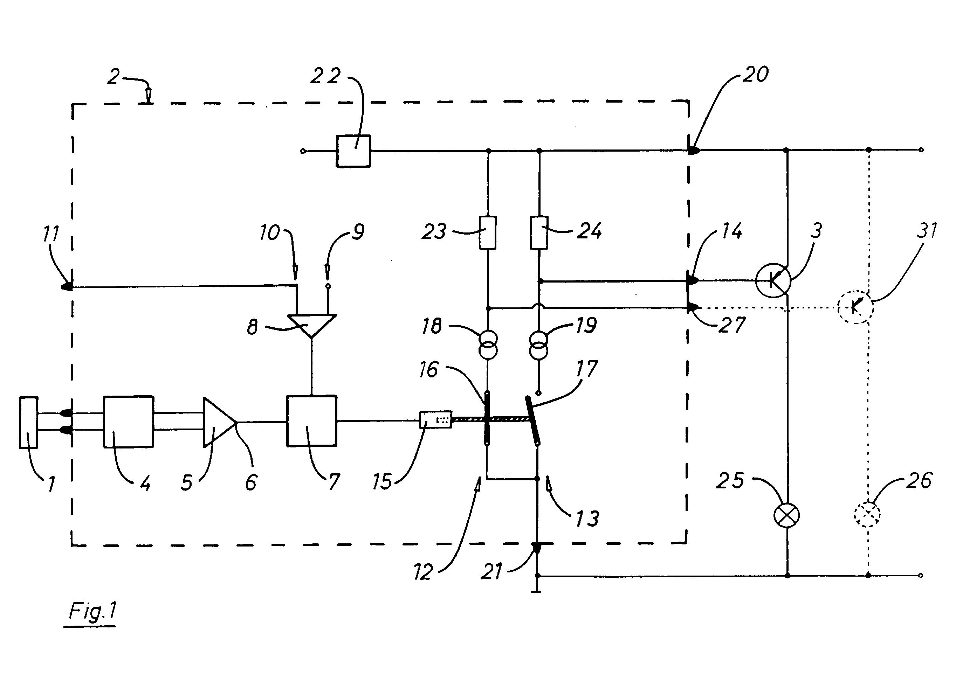

Das in Fig. 1 gezeigte, bekannte Schaltgerät umfaßt eine Sensorstufe 1, die an eine elektronische Schaltung angeschlossen ist, die im wesentlichen aus einem IC 2 und aus einem Lastschalter 3 besteht. Als Lastschalter 3 ist hier ein pnp-Transistor in Emitterschaltung vorgesehen, jedoch sind statt dessen auch andere Lastschalter einsetzbar wie z. B. npn-Transistoren, Triacs oder Thyristoren. Das von der Sensorstufe 1 gelieferte elektrische Signal wird im Verstärker 4 vorverstärkt und einer Auswertestufe 5 zugeführt. Am Ausgang 6 der Auswertestufe 5 steht, entsprechend dem verstärkten Signal der Sensorstufe, der Signalpegel "l" oder "h" in digitaler Form an. Dieses digitale Signal wird einer schaltbaren Inverterstufe 7 zugeführt, die über einen Differenzverstärker 8 ein- oder ausgeschaltet wird, der eine an seinem Referenzspannungseingang 9 anliegende Referenzspannung mit einer am Vergleichsspannungseingang 10 anliegenden Schaltspannung vergleicht. Um diese Schaltspannung ändern zu können, ist der Vergleichsspannungs- bzw. Schalteingang 10 des Differenzverstärkers 8 aus dem IC 2 zu einem IC-Kontakt 11 herausgeführt.

Das Ausgangssignal der Inverterstufe 7 spricht über eine Treibstufensteuerung 15 zwei Treiberstufen 12, 13 an, wobei der Ausgang 14 der ersten Treiberstufe 13 über ihren IC-Anschluß den Lastschalter 3 steuert. Die Funktion der Treiberstufen 12, 13 entspricht der eines Schwachstromrelais, dessen gekoppelte Schaltkontakte 16, 17 Stromquellen 18, 19 ein- bzw. ausschalten, wodurch der Lastschalter 3, bzw. ein gestrichelt gezeichneter Lastschalter 31, angesprochen wird. Die dargestellten Bauelemente 15 bis 19 sind hier nur als Funktionssymbole zu verstehen. Realisiert werden sie durch elektronische Schaltungen, die über die IC-Kontakte 20 und 21 an die Betriebspannung angeschlossen sind, wobei die Stabilisatorschaltung 22 die anliegende IC-interne Betriebsspannung stabilisiert und auch die Referenzspannung für den Differenzverstärker 8 liefert.

Wenn am IC-Kontakt 11 keine Spannung anliegt, ist die Inverterstufe 7 funktionsmäßig ausgeschaltet. Wenn die Sensorstufe 1 nicht ausgelöst ist, liegt am Ausgang 6 der Auswertestufe 5 beispielsweise der Signalpegel "l" an. Dieser Signalpegel wird von der Inverterstufe 7 nicht geändert. Der Eingang der Treiberstufensteuerung 15 liegt auf dem Pegel "l" und hält den Schaltkontakt 16 geschlossen und den Schaltkontakt 17 geöffnet. Der Ausgang 14 der ersten Treiberstufe 13 liegt über dem Widerstand 24 auf dem Pluspotential der Betriebsspannung und sperrt damit den Schalttransistor des Lastschalters 3. Die als Last 25 eingezeichnete Lampe bleibt dunkel. Beim Ansprechen der Sensorstufe 1 auf einen Auslöser liegt am Ausgang 6 der Auswertestufe 5 der Signalpegel "h" vor, der unbeeinflußt von der Inverterstufe 7 über die Treiberstufensteuerung 15 ein Umschalten der Schaltkontakte 16 und 17 bewirkt. Ist der Schalterkontakt 17 geschlossen, bilden der Widerstand 24 und die Treiber-Stromquelle 19 einen Spannungsteiler zwischen der an den IC-Kontakten 20, 21 anliegenden Betriebsspannung und senken das am Treiberstufenausgang 14 anliegende Potential so weit ab, daß der Lastschalter 3 durchschaltet. Es liegt also Schließercharakteristik vor.

Wenn an dem IC-Kontakt 11 eine Schaltspannung angelegt wird, ist die Inverterstufe 7 eingeschaltet. Sofern sich im Bereich der Sensorstufe 1 kein Auslöser befindet, ist das am Ausgang 6 der Auswertestufe 5 anstehende Signal "l" von der eingeschalteten Inverterstufe in "h" gewandelt. Infolgedessen sind dann Schaltkontakt 17 und Lastschalter 3 geschlossen. Wenn die Sensorstufe 1 auf einen Auslöser anspricht, so kehrt sich das Signal der Auswertestufe 5 in "h" um und dieses wird von der Inverterstufe 7 in "l" invertiert, so daß die Treiberstufensteuerung 15 den Schaltkontakt 17 öffnet, wonach auch der Lastschalter 3 öffnet.

Es ist also durch Anlegen einer Schaltspannung an den IC-Kontakt 11 aus einem Schließer ein öffner geworden.

Wenn durch den Näherungsschalter jeweils gleichzeitig eine Last ein- und eine zweite Last ausgeschaltet werden soll, so wird die Schaltung durch den gestrichelt gezeichneten zweiten Lastkreis mit Lastschalter 31 und Last 26 ergänzt und der Lastschalter 31 an den Ausgang 27 der zweiten Treiberstufe 12 angeschlossen. Da die beiden Treiberstufen 12, 13 bereits antivalent arbeiten, werden auch die Lastschalter 3, 31 antivalent geschaltet.

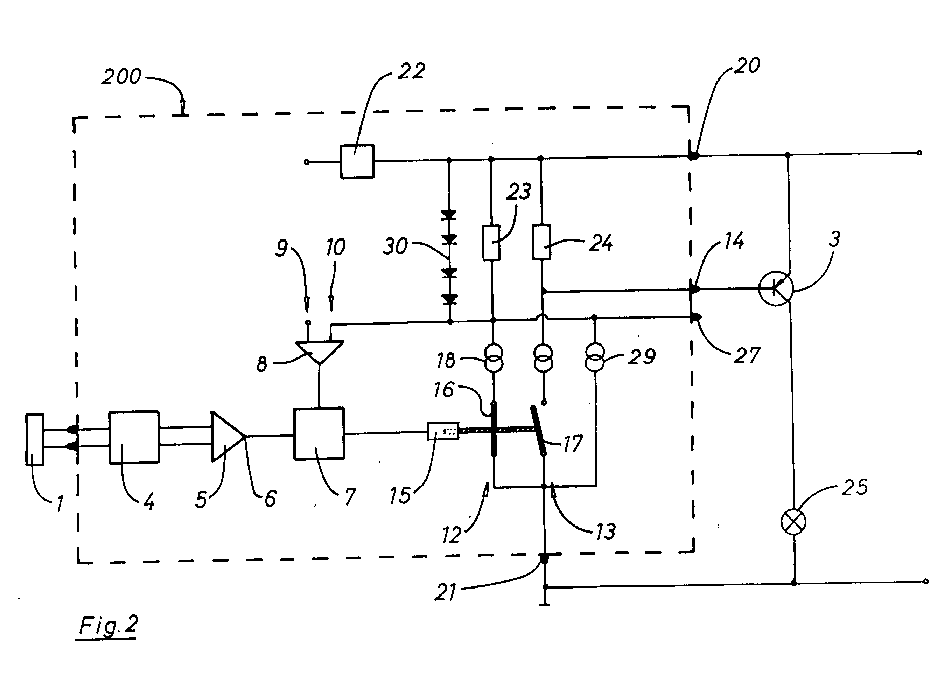

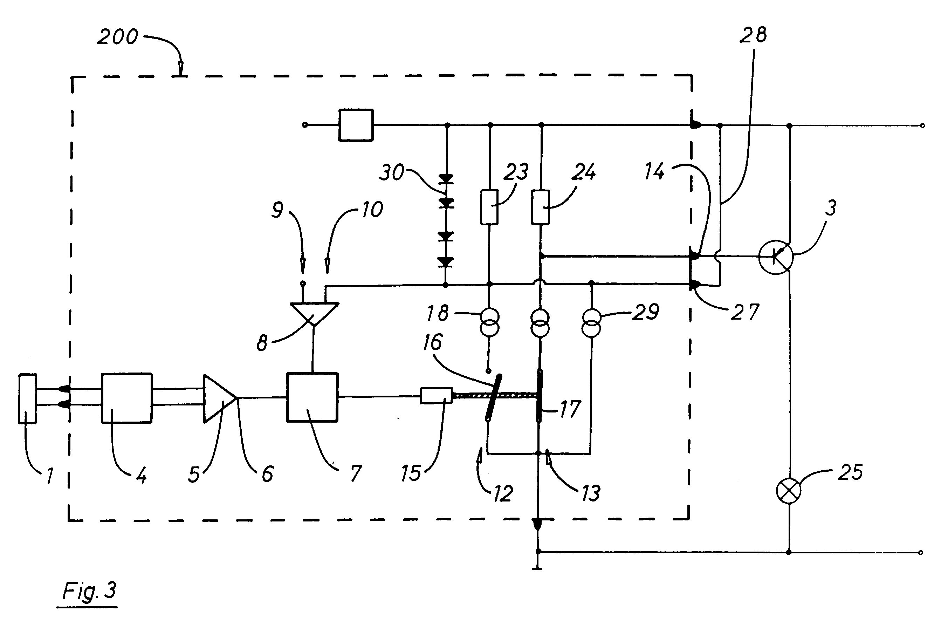

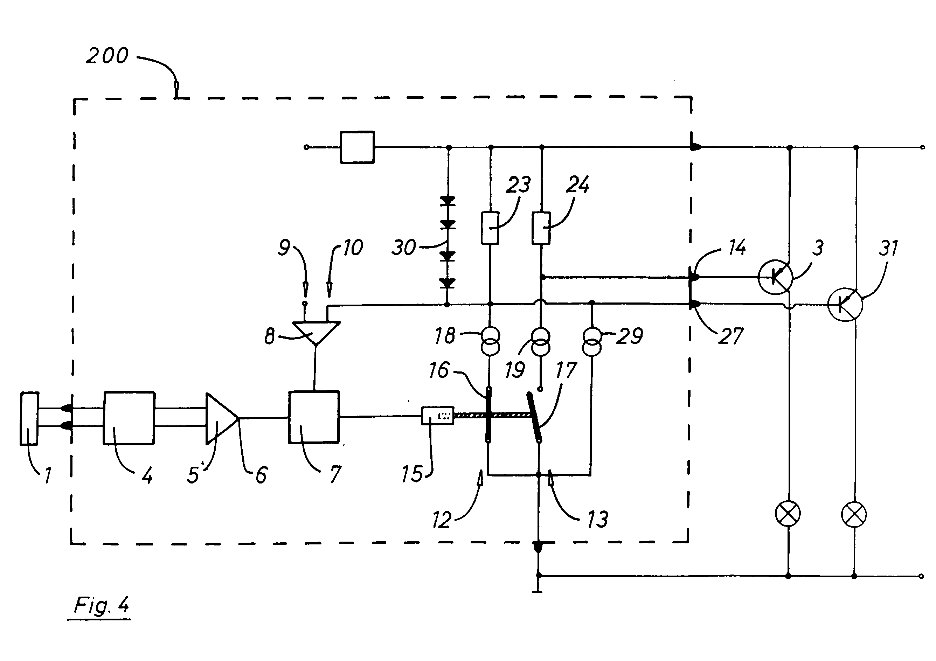

Bei den erfindungsgemäßen Schaltgeräten nach den Fig. 2 (Schließer), Fig. 3 (öffner) und Fig. 4 (zwei antivalent arbeitende Lastschalter) ist eine weitgehend gleichartige IC-Schaltung 200 verwendet, bei der aber im Unterschied zu Fig. 1 der Schalteingang 10 der Inverterstufe 7 zu dem IC-Kontakt des Ausganges 27 der zweiten Treiberstufe 12 geführt ist. Ferner ist eine weitere Konstantstromquelle 29 parallel zur Stromquelle 18 und zum Schaltkontakt 16 der zweiten Treiberstufe 12 geschaltet. Ferner enthält die IC-Schaltung 200 noch eine parallel zum Stromableitwiderstand 23 der zweiten Treiberstufe 12 geschaltete Diodenkette 30.

Bei dem in Fig. 2 gezeigten Schließer bilden der Widerstand 23 und die parallel geschaltete Diodenkette 30 mit den parallel geschalteten Stromquellen 18, 29 einen Spannungsteiler, der das Potential des Treiberstufenausganges 27 der Treiberstufe 12 gegenüber dem Potential der positiven Betriebsspannung deutlich absenkt, so daß der Differenzverstärker 8 die Inverterstufe 7 ausschaltet. Bei Auslösung der Sensorstufe 1 durch einen Auslöser schaltet die Treiberstufensteuerung 15 die Schaltkontakte 16 und 17 um, so daß der Schaltkontakt 17 und der Lastschalter 3 schließen. Da der Schaltkontakt 16 nunmehr geöffnet ist, liegt der Vergleichseingang 10 des Differenzverstärkers 8 an einer Spannung an, die von einem Spannungsteiler erzeugt wird, der einerseits von dem Widerstand 23 in Parallelschaltung mit der Diodenkette 30 und andrerseits durch die weitere Konstantstromquelle 29 gebildet wird. Das so erzeugte, gegenüber dem bei geschlossenem Schalter 16 höhere Potential, reicht aber im Vergleich zum Potential der Betriebsspannung nicht aus, um über den Differenzverstärker 8 die Inverterstufe 7 einzuschalten.

Beim Öffner nach Fig. 3 ist der IC-Kontakt des Ausganges 27 der zweiten Treiberstufe 12 über eine Kurzschlußbrücke 28 an das positive Potential der Betriebsspannung extern angeschlossen. Unabhängig von der Schalterstellung des Schaltkontaktes 16 der Treiberstufe 12 und unabhängig von der weiteren Beschaltung durch die Konstantstromquelle 29 und die Diodenkette 30 bewirkt das bei 27 bzw. am Vergleichseingang 10 anliegende Potential, daß der Differenzverstärker 8 die Inverterstufe 7 einschaltet. Bei Eingangssignal "l" liefert der Inverter das Ausgangssignal "h" und bewirkt damit eine Umschaltung der Schaltkontakte 16, 17 und damit eine Schließung des Lastschalters 3. Reagiert die Sensorstufe 1 auf einen Auslöser, so liegt am Ausgang 6 der Auswertestufe 5 ein Signal "h" vor, was von dem Inverter 7 invertiert wird, so daß die Treiberstufensteuerung 15 den Schaltkontakt 16 schließt und den Schaltkontakt 17 öffnet. Demzufolge liegt die Basis des Schalttransistors des Lastschalters 3 über den Widerstand 24 am Plus-Potential der Betriebsspannung an, so daß der Lastschalter 3 öffnet.

Wie Fig. 4 zeigt, kann der Schließer nach Fig. 2 durch Hinzufügen eines weiteren Lastschalters 31 in ein Schaltgerät mit antivalent arbeitenden Lastschaltern 3, 31 umgewandelt werden. Dazu ist es notwendig, am Ausgang 27 der Treiberstufe 12 gemäß der Stellung des Schaltkontaktes 16 zwei elektrische Zustände derart zu erzeugen, daß der Lastschalter 31 je nach Zustand sicher schließt oder öffnet. Dies wird durch die Wahl eines sehr kleinen Stromes der weiteren Konstantstromquelle 29 gegenüber dem Strom der Konstantstromquelle 18 erreicht. Damit ist sichergestellt, daß einerseits bei geschlossenem Schaltkontakt 16 das Steuerpotential soweit abgesenkt ist, daß der Lastschalter 31 sicher schließt, andererseits bei geöffnetem Kontakt 16 das Eingangspotential des Komparators oder Differenzverstärkers 8 ausreichend niedrig bleibt, so daß die Inverterstufe ausgeschaltet bleibt.

Bei Vorliegen eines Sensorsignals, d. h. wenn der Schaltkontakt 16 geöffnet wird, entfällt die Parallelschaltung der Stromquellen 18, 29 und durch den kleineren Strom der Konstantstromquelle 29 wird das Potential am Ausgang 27 der Treiberstufe 12 gegenüber dem geschlossenen Zustand des Schaltkontaktes 16 soweit angehoben, daß der Lastschalter 31 sicher öffnet. Andrerseits erreicht diese Anhebung des Potentials nicht die Höhe die zur Umschaltung der Inverterstufe 7 notwendig ist.

Die in der Beschreibung das Schaltverhalten der Lastschalter kennzeichnenden Begriffe "Öffner" und "Schließer" folgen aus der Festlegung der Lastschalter auf eine spezielle Transistorschaltung, der Festlegung des Schaltpegels "l" am Ausgang 6 der Auswertestufe 5 und der Festlegung der Grundstellung des Schaltkontaktes 16. Durch Änderung einer oder mehrerer Festlegungen kann das Schaltgerät auch so ausgelegt werden, daß es ohne die Kurzschlußbrücke 28 als "Öffner" und nach Anschließen der Kurzschlußbrücke als "Schließer" arbeitet.

### Bezugszeichenliste

- 1: Sensorstufe
- 2: IC
- 3: Lastschalter
- 4: Verstärker
- 5: Auswertestufe
- 6: Ausgang
- 7: Inverterstufe
- 8: Differenzverstärker
- 9: Referenzspannungseingang
- 10: Schalteingang
- 11: IC-Kontakt
- 12: zweite Treiberstufe
- 13: erste Treiberstufe
- 14: Treiberstufenausgang
- 15: Treiberstufensteuerung
- 16: Schaltkontakt
- 17: Schaltkontakt
- 18: Stromquelle
- 19: Stromquelle
- 20: IC-Kontakt
- 21: IC-Kontakt
- 22: stabilisatorschaltung
- 23: Widerstand
- 24: Widerstand
- 25: Last
- 26: Last
- 27: Treiberstufenausgang
- 28: Kurzschlußbrücke
- 29: Konstantstromquelle
- 30: Diodenkette
- 31: Lastschalter
- 200: IC-Schaltung

## Patentansprüche

1. Elektronisches, vorzugsweise berührungslos arbeitendes Schaltgerät, mit einer von außen beinflußbaren Sensorstufe (1), mit einem von der Sensorstufe steuerbaren elektronischen Lastschalter (3) und mit einer zwischen der Sensorstufe (1) und dem Steuereingang des Lastschalters (3) vorgesehenen, als IC (2) ausgebildeten Schaltung, welche eine Auswertestufe (4) für das Sensorsignal, eine schaltbare Inverterstufe (7) mit Schalteingang (10) und zwei im Gegentakt arbeitende Treiberstufen (12, 13) enthält, wobei der Ausgang (14) der ersten Treiberstufe (13) den Lastschalter (3) ansteuert und der Ausgang (27) der zweiten Treiberstufe (12) - bei der Betriebsart "antivalent" - einen weiteren elektronischen Schalter (31) steuert,
dadurch gekennzeichnet,
daß der Schalteingang (10) der Inverterstufe (7) IC-intern an den Ausgang (27) der zweiten Treiberstufe (12) angeschlossen ist,
daß der Ausgang (27) der zweiten Treiberstufe (12) - für die eine Betriebsart "Schließer" oder "Öffner" - durch einen IC-internen Spannungsteiler (23, 30/18, 29) auf einem Potential gehalten ist, bei dem die Inverterstufe (7) abgeschaltet ist, und daß der zweite Treiberstufenausgang (27) - für die andere Betriebsart "öffner" oder "Schließer" über eine IC-externe Kurzschlußbrücke (28) an das Betriebspotential zwecks Einschaltung der Inverterstufe (7) anschließbar ist.

2. Schaltgerät nach Anspruch 1, dadurch gekennzeichnet, daß der Spannungsteiler einerseits aus dem Stromableitwiderstand (23) der zweiten Treiberstufe (12) und andrerseits aus der schaltbaren Stromquelle (18) der zweiten Treiberstufe und einer hierzu parallel geschalteten, weiteren Konstantstromquelle (29) besteht.

3. Schaltgerät nach Anspruch 2, dadurch gekennzeichnet, daß der Strom der weiteren Konstantstromquelle (29) um etwa zwei Zehnerpotenzen kleiner als der Strom der schaltbaren Treiberstufen-Stromquelle (18) ist.

4. Schaltgerät nach einem oder mehreren der Ansprüche 1 bis 3, dadurch gekennzeichnet, daß parallel zum Stromableitwiderstand (23) der zweiten Treiberstufe (12) eine Diodenkette (30) geschaltet ist, die den maximalen Spannungsabfall am Stromableitwiderstand (23) festlegt.

## Claims

1. Electronic, preferably contactlessly operating switching device, with a sensor stage (1) which can be influenced from the outside, with an electronic circuit breaker (3) controllable by the sensor stage and with a circuit designed as an IC (2), which is provided between the sensor stage (1) and the control input of the circuit breaker (3) and which contains an evaluating stage (4) for the sensor signal, a switchable inverter stage (7) with switching input (10) and two driver stages (12, 13) with push-pull operation, wherein the output (14) of the first driver stage (13) drives the circuit breaker (3) and the output (27) of the second driver stage (12) - in the exclusive OR mode - controls a further electronic switch (31), characterised in that the switching input (10) of the inverter stage (7) is connected, internally to the IC, to the output (27) of the second driver stage (12), in that the output (27) of the second driver stage (12) - for one of the "make" or "break" modes - is kept by a voltage divider (23, 30/18, 29) internal to the IC at a potential at which the inverter stage (7) is switched off, and in that the second driver stage output (27) - for the other of the "break" or "make" modes - can be connected by a short-circuit bridge (28) external to the IC to the operating potential for the purpose of switching on the inverter stage (7).

2. Switching device according to claim 1, characterised in that the voltage divider consists on the one hand of the shunt resistor (23) of the second driver stage (12) and on the other hand of the switchable current source (18) of the second driver stage and a further constant-current source (29) connected in parallel therewith.

3. Switching device according to claim 2, characterised in that the current of the further constant-current source (29) is lower by about two powers of ten than the current of the switchable driver stage current source (18).

4. Switching device according to one or more of claims 1 to 3, characterised in that connected in parallel with the leakage resistor (23) of the second driver stage (12) is a diode chain (30) which fixes the maximum voltage drop at the shunt resistor (23).

## Revendications

1. Dispositif de commutation électronique, fonctionnant de préférence sans contact, comportant un étage de capteur (1) influençable de l'extérieur, comportant un rupteur électronique (3) susceptible d'être actionné par l'étage de capteur (1) et comportant, réalisé sous la forme d'un circuit intégré (I C) (2) et disposé entre l'étage de capteur (1) et l'entrée de commande du rupteur (3), un circuit qui comprend un étage d'évaluation (4) du signal du détecteur, un étage d'inversion (7) commutable avec une entrée de commutation (10) et deux étages d'attaque (12, 13) fonctionnant en push-pull, la sortie (14) du premier étage d'attaque (13) commandant le rupteur (3) et la sortie (27) du second étage d'attaque (12)- selon le mode de fonctionnement "de non-équivalence ou OU exclusif'"- commandant un autre commutateur électronique (31), caractérisé en ce que
l'entrée dc commutation (10) de l'étage d'inversion (7) est reliée intérieurement au circuit intégré à la sortie (27) du second étage d'attaque (12),
la sortie (27) du second étage d'attaque (12) - pour l'un des modes de fonctionnement "ouverture" ou "fermeture"- est maintenue par un diviseur de tension (23, 30/18, 29) à un potentiel pour lequel l'étage d'inversion (7) n'est pas activé, et en ce que la deuxième sortie (27) de l'étage d'attaque - pour l'autre mode de fonctionnement "ouverture" ou "fermeture"- est susceptible d'être reliée au potentiel de fonctionnement par un pont de court-circuit (28) extérieur au circuit intégré pour effectuer un basculement de l'étage d'inversion (7).

2. Dispositif de commutation selon la revendication 1, caractérisé en ce que le diviseur de tension consiste d'une part en la résistance de dérivation (23) du second étage d'attaque (12) et, d'autre part, en la source de courant commutable (18) du second étage d'attaque (12) et en une autre source de courant constant (29) qui lui est raccordée en parallèle.

3. Dispositif de commutation selon la revendication 2, caractérisé en ce que le courant de cette autre source de courant constante (29) est inférieur d'environ deux puissances de dix au courant de la source de courant commutable (18).

4. Dispositif de commutation selon l'une des revendications 1 à 3, caractérisé en ce que, parallèlement à la résistance de dérivation (23) du second étage d'attaque (12), est branchée une série de diodes (30), qui détermine la chute de tension maximale dans la résistance de dérivation (23).
